# EUROPEAN PATENT APPLICATION

(11) **EP 3 599 799 A1**
(43) Date of publication of application: **29.01.2020**
(21) Application number: 19154723.1
(22) Date of filing: 31.01.2019
(51) Int. Cl.: H05K 1/11, H01R 12/72

(54) **LADDER TYPE PCB FOR HIGH LAYER COUNT GOLDEN FINGER CARD DESIGN**

(30) Priority: 23.07.2018 US 201816042208
(71) Applicant: Quanta Computer Inc., Taoyuan City 333 (TW)
(72) Inventor: HSU, Yu-Tsung, Taoyuan City (TW); LEE, Cheng-Hsien, Taoyuan City (TW)
(74) Representative: D Young & Co LLP

(57) **Abstract**

This disclosure relates to a Golden Finger card design where the PCB edge has a first thickness, but the main body of the PCB is of increased thickness to accommodate application complexity. The increased thickness in the body portion provides greater dielectric material between traces, thereby reducing loss. By maintaining the edge of the PCB fingers at a first thickness, the use of existing connectors, such as standard PCIe connectors, is maintained. Golden Finger cards of this disclosure are used as a video and graphics card, network adapter card, audio adapter card, and television or other specialty adapter card.

## Description

### FIELD

This disclosure relates to a Golden Finger card design where the main body of the printed circuit board ("PCB") is increased in thickness without increasing PCB finger thickness. By maintaining the width of the edge of the PCB fingers, use of existing connectors is maintained. Meanwhile, the main body of the PCB is not limited in thickness, so as to accommodate additional PCB layers and thus, increased application complexity. Golden Finger cards of this disclosure can be used as a video and graphics card, network adapter card, audio adapter card, and television or other specialty adapter card.

### BACKGROUND

A Golden Finger card is frequently used in server/storage product designs. However, due to connector limitations, the board thickness is typically standardized and fixed (normally 1.57 mm). However, as application complexity increases, the number of signal traces required also increases for Golden Finger cards. Hence, a higher layer count PCB is necessary. However, a limitation on the fixed board thickness would result in the dielectric thickness of the PCB layers becoming thinner, thereby causing higher trace loss and reduced signal margins. Thus, there is a need for Golden Finger cards that allow for an increased number of layers while maintaining connector compatibility, reduced trace loss, and high signal margins.

### SUMMARY

A ladder type PCB contains two or more different board thicknesses. The Golden Finger edge has a first board thickness (e.g., 1.57 mm [± 0.15 mm]) so as to mate with existing connectors. However, outside of edge thickness limitations, there are no limitations on the thickness of the remainder of the board. Hence, in one embodiment of this disclosure, the main body of the board may have a larger thickness (e.g., greater than 1.57 mm). An example of such a board would have a body thickness of about twice as thick as the first thickness, or about 2.4 mm (± 0.24 mm), while the edge thickness is maintained at 1.57 mm (± 0.15 mm).

There are no limitations for a ladder type PCB design. Hence, in another embodiment of this disclosure, the PCB could contain a one side ladder.

In yet another embodiment of this disclosure, the PCB could have two side ladders.

In a still further embodiment, in a PCB having a 2.4 mm board thickness (± 0.24 mm), it is possible to construct 16-layer Golden Finger card with a general composition of 4 mil core, 16 mil prepreg. By comparison, a traditional Golden Finger card will have a specific composition of 3 mil core, 3 mil prepreg, which will result in larger PCB trace loss and reduced design margins. Further particular and preferred aspects of the present invention are set out in the accompanying independent and dependent claims. Features of the dependent claims may be combined with features of the independent claims as appropriate, and in combinations other than those explicitly set out in the claims.

### BRIEF DESCRIPTION OF THE DRAWINGS

The disclosure, and its advantages and drawings, will be better understood from the following description of exemplary embodiments together with reference to the accompanying drawings. These drawings depict only exemplary embodiments, and are therefore not to be considered as limitations on the scope of the various embodiments or claims.
FIG. 1 (Prior Art) is a schematic illustration of the joining of a golden finger card having a thickness of 1.57 mm with a standard connector.
FIG. 2 shows the same standard connector as in FIG. 1 joined to a golden finger card of the present disclosure, where the main body of the board has a thickness of 2.4 mm while maintaining the board edge thickness at 1.57 mm.
FIG. 3 is a schematic representation of a side view of a 2.4 mm double ladder PCB in which it is possible to construct 16-layer golden finger card with general configuration (4 mil core, 16 mil prepreg).
FIG. 4 is a graphic representation of PCB trace loss for a traditional golden finger card, as compared to the trace loss for a ladder type golden finger card.
FIG. 5A is a schematic depiction of a two-sided ladder golden finger card.
FIG. 5B is an enlarged view of a portion of FIG. 5A to show detail of the golden fingers.
FIG. 5C is an enlarged view of a portion of FIG. 5A to show details of the main body of the PCB.

### DETAILED DESCRIPTION

The present invention is described with reference to the attached figures, where like reference numerals are used throughout the figures to designate similar or equivalent elements. The figures are not drawn to scale and are provided merely to illustrate the instant invention. Several aspects of the invention are described below with reference to example applications for illustration. It should be understood that numerous specific details, relationships, and methods are set forth to provide a full understanding of the invention. One having ordinary skill in the relevant art, however, will readily recognize that the invention can be practiced without one or more of the specific details, or with other methods. In other instances, well-known structures or operations are not shown in detail to avoid obscuring the invention. The present invention is not limited by the illustrated ordering of acts or events, as some acts may occur in different orders and/or concurrently with other acts or events. Furthermore, not all illustrated acts or events are required to implement a methodology in accordance with the present invention.

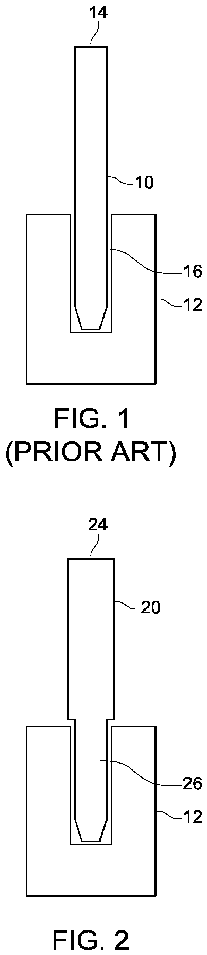

FIG. 1 (Prior Art) is a schematic illustration of the joining of a Golden Finger card 10 having a nominal thickness of 1.57 mm with a standard PCIe connector 12. The body 14 of the Golden Finger card 10 has the same 1.57 mm thickness as the finger portion 16 of the card. As discussed above, such a conventional configuration is limiting, as the only way to increase application complexity would be to implement thinner dielectric layers. However, as discussed above, such a configuration is undesirable.

In view of the limitations of the configuration of FIG. 1, the configuration of FIG. 2 is presented. FIG. 2 is also a schematic illustration of the joining of a Golden Finger card 20 according to the present disclosure, but with two different thickness regions. As shown in FIG. 2, the Golden Finger card 20 can mate with the same standard PCIe connector 12 (in FIG. 1). That is, the Golden Finger portion 26 has the same thickness as a conventional golden finger card, such as the Golden Finger card 10 (in FIG. 1). However, in addition to the Golden Finger portion 26, the Golden Finger card 20 has body portion 24 with a thickness that is different from the Golden Finger portion 26. As a result, application complexity can be increased without relying on thinner dielectric layers.

In a particular example, the Golden Finger portion 26 can have the same 1.57 mm nominal thickness as to fit into a standard connector, such as the PCIe connector 12, while the body portion 24 of the Golden Finger card 20 can be thicker than the Golden finger portion 26 of the card. There is generally no limit to the thickness of the body portion 24 of the Golden Finger card 20. Further, such cards can be configured as single ladder or a double ladder cards. In certain configurations, thicknesses of 2.4 mm have been found suitable for the body portion 24 to accommodate increased application complexity, while still retaining the 1.57 mm thickness limitation of the Golden finger portion 26 in order to fit into the standard connector 12.

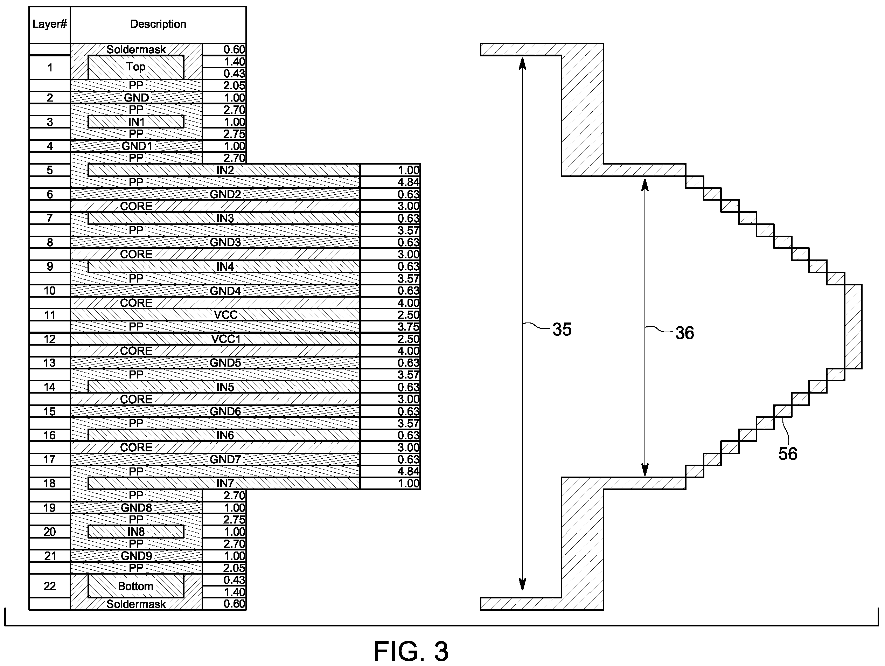

FIG. 3 is a side view and construction of ladder type golden finger card. It is a 22 layer, double side ladder card, with layers 1 to 4 and 19 to 22 removed at golden finger side. Therefore, FIG. 3 is a schematic representation of a double ladder golden finger board where the body portion has a thickness greater than the golden finger portion. With a 2.4 mm board thickness, it is possible to construct 16-layer Golden Finger card with general composition (4 mil core, 16 mil prepreg). By comparison, a traditional Golden Finger card will have the specific composition (3 mil core, 3 mil prepreg) which will result in larger PCB trace loss and reduced design margins. Distance 35 has a mask-to-mask length of about 95.4 mils, and distance 36 has a gold finger-to-gold finger length of about 62.4 mils.

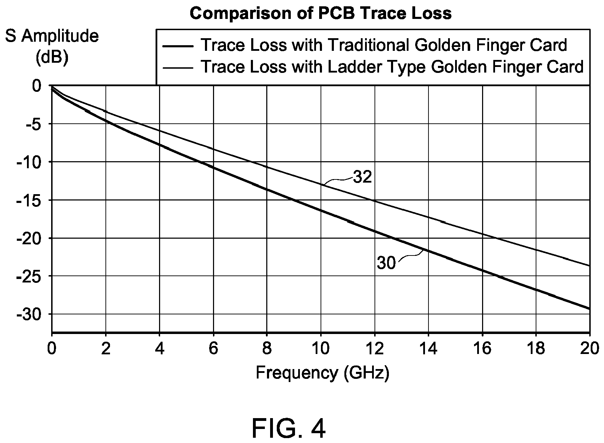

FIG. 4 is a graphic representation of the trace loss of a traditional Golden Finger card 30, as compared to a trace loss of a ladder type Golden Finger card 32, according to the present disclosure over a range of frequencies from 0 to 20 GHz. As shown in FIG. 4, the trace loss is improved for a ladder type Golden Finger, as compared to a traditional golden finger. Further, as also shown in FIG. 4, the improvement is increased as frequency is increased. Thus, implementing a ladder type design would lead to greater design margin and higher reliability.

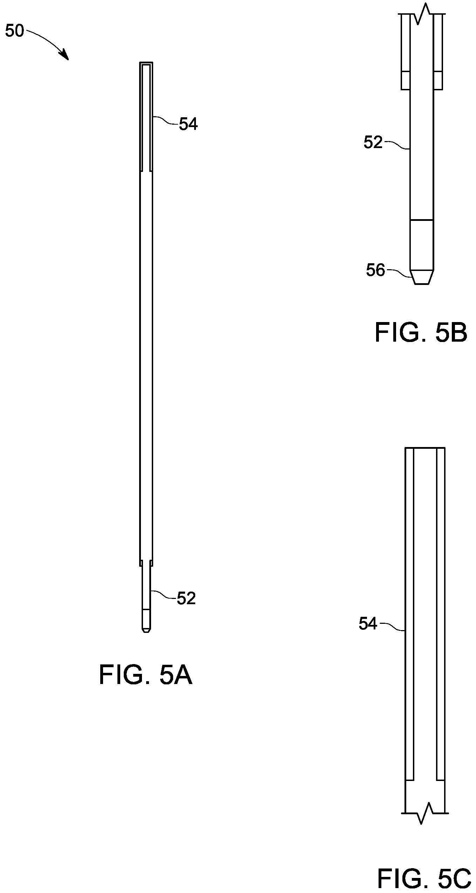

The taper structure of the golden finger card is due to the mechanical characteristic features of a PCIe connector into which the golden finger card is insertable. All golden finger card should have taper in order to fit into the dimensions of a standard PCIe connector. The golden finger is directly connected to traces in the body portion of the board. The fingers go straight through the card to connect to traces by way of visa. They will transit to any layer by via in body of the board. However, by making the body of the board thicker beyond the finger portion of the board, there will be more dielectric material between traces. This additional dielectric material between traces is a structural feature of the boards of this disclosure which will allow for lower loss. Because the board thickness is not limited in the body side of the board, we can increase the amount of dielectric between traces, thereby limiting loss, while not affecting the dimensions of the finger portion of the board which will still fit into a standard PCIe connector. FIG. 5A is a schematic representation of a ladder type PCB 50 containing two or more different types of board thicknesses. The ladder type PCB has a thickness of 1.57 mm at the Golden Fingers edge 52 and a thicker body portion thickness 54.

FIG 5B is an enlarged view of a portion of FIG. 5A containing the Golden Fingers edge 52. It can be seen that the end of the edge 56, comprising the Golden Finger portion 26, is tapered at an angle of about 20°± 5° for the first thickness 1.4 mm (± 0.25 mm) from the edge of the Golden Finger card 20 (in FIG. 2). If desired, the above taper could be placed on each side of the Golden Fingers edge portion 26, as shown in FIG. 5B.

FIG. 5C is an enlarged view of a portion of FIG. 5A illustrating the thickness of the body portion thickness 54 of the board. A single ladder PCB increases the thickness of the PCB 50 by about 0.415 mm. A double ladder PCB would increase about 0.830 mm in thickness making the PCB 50 body thickness about 2.4 mm (± 0.24) in total thickness.

The terminology used herein is for the purpose of describing particular embodiments only and is not intended to be limiting of the invention. As used herein, the singular forms "a," "an," and "the" are intended to include the plural forms as well, unless the context clearly indicates otherwise. Furthermore, to the extent that the terms "including," "includes," "having," "has," "with," or variants thereof are used in either the detailed description and/or the claims, such terms are intended to be inclusive in a manner similar to the term "comprising."
Although particular embodiments have been described herein, it will be appreciated that the invention is not limited thereto and that many modifications and additions thereto may be made within the scope of the invention. For example, various combinations of the features of the following dependent claims can be made with the features of the independent claims without departing from the scope of the present invention.

## Claims

1. A Golden Finger card comprising:
a Golden Finger card edge (52) having a first thickness; and
a Golden Finger card body portion (24), wherein the Golden Finger card body portion (24) has a thickness greater than the first thickness.

2. The Golden Finger card of claim 1, wherein the Golden Finger card body portion (24) is a single sided ladder PCB.

3. The Golden Finger card of claim 2, wherein the single sided ladder PCB (24) adds a thickness to only one side of a body of the single sided ladder PCB.

4. The Golden Finger card of claim 1, wherein the Golden Finger card body portion (24) is a double sided ladder PCB.

5. The Golden Finger card of claim 4, wherein the double sided ladder PCB (24) adds a thickness on each side of a body of double sided ladder PCB.

6. The Golden Finger card of any of claims 1-5, wherein the first thickness is of a size that fits a standard connector (12).

7. The Golden Finger card of any of claims 1-6, wherein the Golden Finger card edge (52) exhibits a taper (56).

8. The Golden Finger card of any of claims 1-7, wherein each edge (52) of the Golden Finger card exhibits a taper (56).

9. The Golden Finger card of any of claims 1-8, wherein an increased thickness of dielectric material between traces in the Golden Finger card body portion (24) exhibits a trace loss of less than 25 dB at a frequency of 20 GHz.

10. A Golden Finger card comprising:
a Golden Finger card edge (52) having a first thickness; and
a Golden Finger card body portion (24), wherein the Golden Finger card body portion (24) has a thickness of about 1.5 times the first thickness.

11. The Golden Finger card of claim 10, wherein the Golden Finger card edge (52) exhibits a taper (56).

12. The Golden Finger card of claim 10 or claim 11, wherein each edge (52) of the Golden Finger card exhibits a taper (56).

13. The Golden Finger card of any of claims 10-12, wherein an increased thickness of dielectric material between traces in the Golden Finger card body portion (24) exhibits a trace loss of less than 25 dB at a frequency of 20GHz.

14. The Golden Finger card of any of claims 10-13, wherein the first thickness is about 1.57 mm.

15. The Golden Finger card of any of claims 10-14, wherein the thickness of the Golden Finger card body portion (24) is about 2.4 mm.
